# EUROPEAN PATENT APPLICATION

(11) **EP 2 940 179 A1**
(43) Date of publication of application: **04.11.2015**
(21) Application number: 13868160.6
(22) Date of filing: 19.12.2013
(51) Int. Cl.: C23C 14/22, C23C 14/26

(54) **EVAPORATION SOURCE FOR TRANSPORTING CHEMICAL PRECURSORS, AND EVAPORATION METHOD FOR TRANSPORTING CHEMICAL PRECURSORS USING SAID SOURCE**

(30) Priority: 28.12.2012 ES 201232063
(71) Applicant: Abengoa Solar New Technologies, S.A., 41014 Sevilla (ES)
(72) Inventor: SANCHO MARTINEZ, Diego, E-41014 Sevilla (ES); DELGADO SANCHEZ, José María, E-41014 Sevilla (ES); MARQUEZ PRIETO, José Antonio, E-41014 Sevilla (ES); SANCHEZ CORTEZON, Emilio, E-41014 Sevilla (ES)
(74) Representative: Carvajal y Urquijo, Isabel
(86) International application number: PCT/ES2013/070901
(87) International publication number: WO 2014/102423

(57) **Abstract**

The invention presents an evaporation source for transporting chemical precursors to a substrate on which the latter are deposited by means of condensation, formed by a principal tube (1) which houses the precursors in its lower part, and which has heating means (8). An inlet (5) and an outlet (6) for carrier gases is arranged in the upper part of the principal tube (1), said inlet (5) and outlet (6) being located on the lateral surface (7) of the principal tube (1), opposing each other and aligned along a common line which passes transversally through the lateral surface (7) of the principal tube (1).

The invention also presents a method of evaporation for transporting chemical precursors in which introducing and extracting the carrier gases from the principal tube (1) is carried out in alignment in a direction transversal to the lateral surface (7) of the latter.

## Description

### Field of the invention

The present invention belongs to the technical field of the deposition of chemical precursors on a substrate, specifically to the techniques of deposition by means of transporting evaporated precursors by means of carrier gases towards the substrate (VTD, Vapor Transport Deposition), applied, for example for creating coatings or in the manufacture of photovoltaic cells. The invention relates in particular to an evaporation source for transporting chemical precursors to a substrate and to the method of evaporation for transporting these chemical precursors which uses the aforementioned source.

### Background of the invention

At present, there are different deposition techniques which use the transportation of the evaporated precursors, or elements to be deposited, to a substrate on which they are deposited by condensation, and which are used in numerous applications such as coatings or the manufacture of photovoltaic cells.

CSS (Close Space Sublimation) is an evaporation technique which is based on heating precursors until its evaporation and the condensation of these on a substrate which is placed directly on top of the evaporator. Therefore, this technique does not use any entrainment or carrier gas to transport the evaporated precursors in a gaseous state from one point to another.

However, the technique for transporting the evaporated precursors by means of carrier gases (VTD, Vapor Transport Deposition) is an evaporation technique similar to CSS but with the unique feature that an entrainment or carrier gas is used to transport the evaporated precursors from the evaporation source to the substrate, which is located at a determined distance and in a fixed position. This technique enables the deposition of precursors on substrates arranged at considerable distances from the evaporation source.

In this VTD technique, the usual design for the inlet and outlet of the gases in the evaporation source is carried out through the upper part of the latter and perpendicular to the surface on which the precursors are located. Generally the precursors are located on the lower part of a principal hollow tube and the inlet and outlet tubes for the carrier gases are located in the upper part of the tube, orientated towards the precursors, that is to say, in a direction parallel to the longitudinal direction of the tube. This design has the problem that when the carrier gases directly impinge on the substrate, they actually impact the latter, creating a turbulent flow, and end up entraining solid unevaporated substances from the precursor. Therefore, the deposition on the substrate will not be what was expected in terms of quantity and quality, and in addition, these solid substances, which the carrier gases transport, can end up obstructing the transport tubes for the carrier gas, damaging the equipment and affecting its functioning.

An evaporation system for transporting chemical precursors has therefore become desirable, which provides a smooth controlled entrainment and in a regime which is as laminar as possible, preventing the entrainment of solid unevaporated particles from the precursor, preventing the drawbacks existing in the systems of the prior art and a suitable control of the concentration of the evaporated precursor in the carrier gas, as well as reducing the consumption of said carrier gas.

### Description of the invention

The present invention resolves the problems existing in the prior art by means of an evaporation source for transporting chemical precursors to a substrate on which these precursors are deposited by means of condensation. The source is formed by a principal tube with lower and upper removable caps for easy access to all the parts of its interior. The principal tube can be made of stainless steel, copper, titanium etc., coated or not with some type of alloy to offer better tolerance to temperature and corrosion. This coating can be nickel, vanadium, molybdenum, chrome or other mixtures of materials. The tube can have dimensions from 10 up to 100 millimeters in diameter, or as the case may be, even up to 1000 millimeters in diameter, depending on the quantity of precursor and the rate of deposition which is required. The height of the tube can vary depending on the configuration of the inlet for the carrier gases and on the quantity of precursor which is going to be evaporated; it can be from 10 up to 100 millimeters or greater if required.

The tube houses in its interior the precursors which are going to be evaporated and transported by means of carrier or entrainment gases.

The precursors which can be used must have chemical characteristics suitable for them to evaporate given the physical limits which they can reach through the tools used. Examples of precursors may be halides, such as chlorides or fluorides of copper, gallium, selenium, indium, zinc, magnesium sulfate, cadmium sulfate, tellurium sulfate, etc. The choice of the precursor materials to be evaporated will depend on which material is to be formed on the substrate when condensing the transported precursors.

Specifically, these precursors are housed in the lower part of the tube, while in the upper part of the latter an inlet is arranged, through which a carrier gas inlet tube is connected to the interior of the principal tube and an outlet, through which a carrier gas outlet tube is connected to the interior of the principal tube; the carrier gases, already with the precursors evaporated, circulate through this tube to be transported to the substrate.

Both the gas inlet tube to the principal tube and the gas outlet tube, in a conventional manner, can be made of stainless steel, copper, titanium, etc., coated or not with some type of alloy to offer better tolerance to temperature and corrosion. This coating can be nickel, vanadium, molybdenum, chrome or other mixtures of materials. These inlet and outlet tubes can have dimensions from 1 up to 10 millimeters in diameter, or even up to 100 millimeters in diameter as the case or requirements may be, depending on the quantity of precursors and the rate of deposition which is desired to be obtained. The length of this tube depends on the distance the evaporated precursors have to be transported.

The gas inlet and outlet tubes can be connected to the principal tube directly into orifices made in the latter for this purpose, or joined to the principal tube by different means, such as by means of screwing, by means of welding, or using intermediate connectors previously joined to orifices made in the principal tube.

Conventionally, the entrainment system can have a vacuum system which causes the gases to flow better through the tubes. That is to say an entrainment system can be used that is formed exclusively by gases, whereby the gases are injected through one end of the gas inlet tube, while extraction thereof through the rear end of the gas outlet is not facilitated, or a dual system can be used in which, at the same time as gases are injected, extraction thereof is assisted through the outlet tube. Depending on the system selected, it is possible to have one or another process pressure, which facilitates or hinders the aim to be achieved.

In terms of the carrier or entrainment gases, these can conventionally be argon, nitrogen, oxygen, any noble gas, hydrogen, fluorine, chlorine or some mixture of the aforementioned gases. The gas flows used can be from 1 up to 200 sccm (standard cubic centimeters per minute) or even up to 1000 sccm as required.

In order to successfully evaporate the precursors, the evaporation source, which is the object of the present invention, has heating means connected to the lateral surface of the principal tube which can consist of a resistor coiled around the principal tube or inserted therein or one or a number of heating lamps arranged externally to the tube.

These heating means can preferably be coated with a thermally insulating and non-conductive material, such as for example a ceramic material to avoid fluctuations in the selected temperature.

In order to control the temperature in the interior and on the exterior of the principal tube, temperature gauges are provided (thermocouples, PT1000, etc.) inside and/or outside of the latter. These gauges are preferably resistant to corrosion.

Specifically, in the present invention, the inlet and outlet are arranged on the lateral surface of the principal tube, opposing each other and aligned along a common line which passes transversally through the lateral surface of the principal tube. Preferably, the inlet and outlet are aligned along a common line perpendicular to the lateral surface of the principal tube. Given that the inlet and outlet tube are preferably arranged forming a right angle with the principal tube, the circulation of the carrier gases is essentially parallel to the surface on which the precursors are arranged and at a considerable distance from the latter.

Preferably the inlet and outlet are arranged in alignment along a common line perpendicular to the lateral surface of the principal tube and diametrically opposed with respect to the axis of the principal tube, although said inlet and outlet can also have a slight deviation in angle.

In this way, the carrier gases enter the principal tube without impacting the precursors and separated at a certain distance from the latter. Furthermore, the gases enter in a direction parallel to the surface of the precursors which are evaporated. Thus the evaporated material ascends through the principal tube and meets the carrier gas flow and the carrier gases only collect the evaporated precursors, maintaining a laminar regime, or as close as possible to this, and exit through the outlet of the principal tube, being driven to the substrate on which the deposition is carried out by means of condensation.

Therefore, the source object of the invention, has the advantage that, owing to its configuration, the carrier gas does not move or entrain solid unevaporated substances from the precursor. Therefore, it prevents the solid particles from being entrained by the carrier gas toward the substrate, which would alter the deposition of the precursor onto the latter. Furthermore, it also prevents part of the solid entrained particles from obstructing the pipes, leading them to become blocked and damaged, as occurs in the devices existing in the prior art.

There are different alternatives for the passage between the inlet and the outlet for the carrier gases.

According to one of them, the gas inlet tube is connected to the inlet and the gas outlet tube to the outlet of the principal tube, and in the interior of said principal tube there is no physical communication between the inlet and the outlet, the gases passing from the inlet to the outlet through the interior of the tube directly. Thus, the gas inlet and outlet tubes are fixed to the exterior face of the principal tube, the interior of said principal tube being hollow.

Alternatively, the inlet and the outlet of the principal tube can be connected through the interior of the latter by means of a straight through-connection tube, which has at least one opening or various indentations on the area shared with the principal tube. In this way, the flow continues to be as laminar as possible and attempts to entrain the greatest possible quantity of evaporated precursor.

According to a different alternative, the source has one or a plurality of separation elements in the interior of the principal tube, in the form of a plate or sheet, which separates the lower part from the upper part of the latter. This separation element has indentations or holes. Thus, there is an isolated area in the upper part of the principal tube where the gas inlet and outlet tubes are arranged such that they are fixed to the exterior face of this principal tube. The evaporated precursors pass through the indentations or holes of the separation element and reach the entrainment flow.

Additionally, the present invention relates to a method of evaporation for transporting chemical precursors, which uses the source previously described. In this method, the precursors are arranged in the lower part of the principal tube and heating of the precursors is carried out by means of the heating means of the principal tube until they evaporate. Furthermore, carrier gases are introduced by means of an inlet tube connected to the inlet of the principal tube, and the carrier gases are extracted together with the evaporated precursors by means of an outlet tube connected to the outlet of the principal tube. This introduction and extraction of the carrier gases from the principal tube is carried out in alignment and in a direction transversal to the lateral surface of the principal tube, preferably in a direction perpendicular to the lateral surface of the principal tube.

Therefore, by means of the method, which is the object of the present invention, the solid particles of the precursor are prevented from being entrained by the carrier gas to the substrate, altering the deposition of the precursors on the latter and furthermore the solid particles entrained by the carrier gas are prevented from obstructing the pipes, damaging the latter and affecting the deposition, as occurs in the methods existing in the prior art. Furthermore, with this arrangement of the inlet and outlet tubes, the evaporation of the precursors is facilitated due to the pressure difference which is produced by the Venturi effect.

By means of the source and the method of the present invention, it is verified that the transported mass of evaporated precursor is high, approximately 100%, when the transport of the solid-state precursor disappears almost completely, which confirms the efficiency of the present invention.

### Brief description of the drawings

In order to make the invention more readily understandable, an embodiment of the invention is described below in an illustrative and non-limiting manner, with reference to a series of figures.

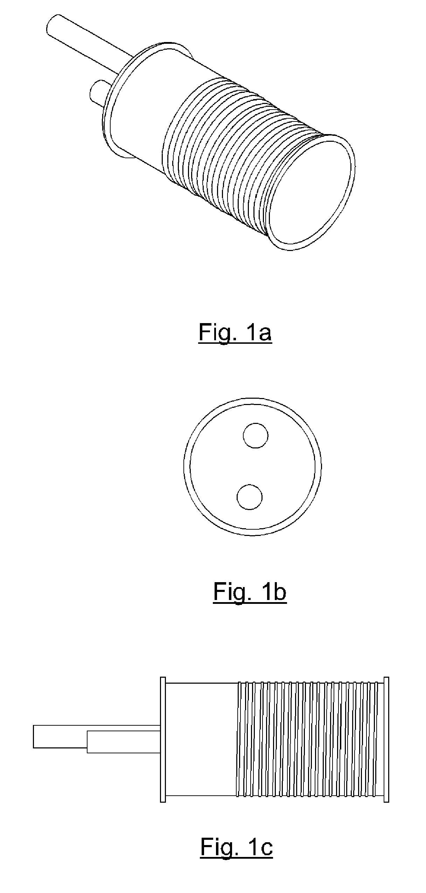

Figure 1a is a perspective view of an evaporation source for transporting chemical precursors existing in the prior art. Figure 1b is a plan view of the source of Fig. 1a. Figure 1c is an elevation view of the source of Figures 1a and 1b.
Figure 2a is a perspective view of an embodiment of an evaporation source for transporting chemical precursors which is the object of the present invention. Figure 2b is a plan view of the source of Figure 2a. Figure 2c is an elevation view of the source of Figures 2a and 2b.
Figure 3a is a perspective view of an alternative embodiment of an evaporation source for transporting chemical precursors which is the object of the present invention. Figure 3b is a plan view in cross section. Figure 3c is a cross-sectional elevation view of the source of Figures 3a and 3b.
Figure 4a is a perspective view of another, different embodiment of an evaporation source for transporting chemical precursors which is the object of the present invention. Figure 4b is a plan view in cross section. Figure 4c is a cross-section view of the source of Figures 4a and 4b.

In these figures, reference is made to a group of elements which are:
1. principal tube
2. caps of the principal tube
3. lower part of the principal tube
4. upper part of the principal tube
5. inlet of the principal tube
6. outlet of the principal tube
7. lateral surface of the principal tube
8. heating means
9. carrier gas inlet tube
10. carrier gas outlet tube
11. connection tube of the inlet and outlet of the principal tube
12. opening of the connection tube
13. separation element of the principal tube
14. indentations or holes of the separation element

### Detailed description of the invention

An object of the present invention is an evaporation source for transporting chemical precursors to a substrate on which the chemical precursors are deposited by means of condensation.

As can be observed in the figures, the source, which is the object of the present invention, is formed by a hollow principal tube 1 with lower and upper removable caps 2 to provide access to its interior, which houses the precursors.

Particularly, the principal tube 1 is made of a metallic material which can be stainless steel, copper, titanium or a combination of a number of these. Furthermore, a coating made of an alloy of such elements as nickel, vanadium, molybdenum, chrome and a combination of these may be present.

The principal tube is divided into a lower part 3 in which the precursors are housed and an upper part 4.

In the upper part 4, an inlet 5 is arranged, through which a carrier gas inlet tube 9 is connected to the interior of the principal tube 1 and an outlet 6 through which a carrier gas outlet tube 10 is connected to the interior of the principal tube 1. Particularly the gas inlet 9 and outlet 10 tubes can be connected directly to the principal tube 1, to the inlet 5 and outlet 6, respectively, or joined to the principal tube 1 by different means such as by means of screwing, by means of welding or using intermediate connectors previously joined to the inlet 5 and the outlet 6 of the principal tube 1.

The heating means 8 are connected to the lateral surface 7 of the principal tube 1 and cause the precursors to evaporate.

In a particular manner, as has been previously indicated, the heating means 8 can be formed by a resistor arranged around the principal tube 1 already coiled or inserted therein. Alternatively, the heating means 8 can consist of at least one heating lamp arranged externally to the principal tube 1.

In order to control the temperature in the interior and on the exterior of the principal tube 1, gauges (thermocouples for example) can be used, arranged both in the interior and on the exterior of the latter.

In the present invention, the inlet 5 and outlet 6 of the principal tube 1 are arranged on the lateral surface of the latter, opposing each other, and aligned along a common line which passes transversally though the lateral surface 7 of the principal tube 1. Preferably, as shown in the figures, the inlet 5 and outlet 6 are arranged in alignment along a common line arranged perpendicularly to the lateral surface 7 of the principal tube 1.

As has been indicated previously, there are different alternatives for the connection between the inlet 5 and the outlet 6 for the carrier gases.

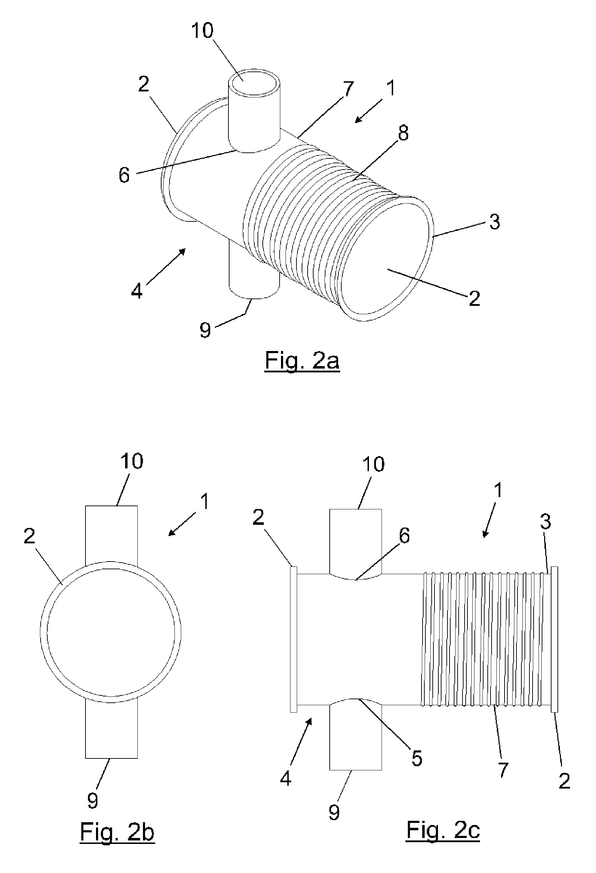

According to one of these alternatives, the gas inlet tube 9 is connected to the inlet 5 and the gas outlet tube 10 is connected to the outlet 6 of the principal tube 1 and in the interior of said principal tube 1 there is no physical communication between the inlet 5 and outlet 6, the gases passing from the inlet 5 to the outlet 6 directly through the interior of the principal tube 1. Thus the gas inlet 9 and outlet 10 tubes are fixed to the exterior face of the principal tube 1, the interior of said principal tube 1 being hollow. This embodiment is shown in Figures 2a, 2b and 2c.

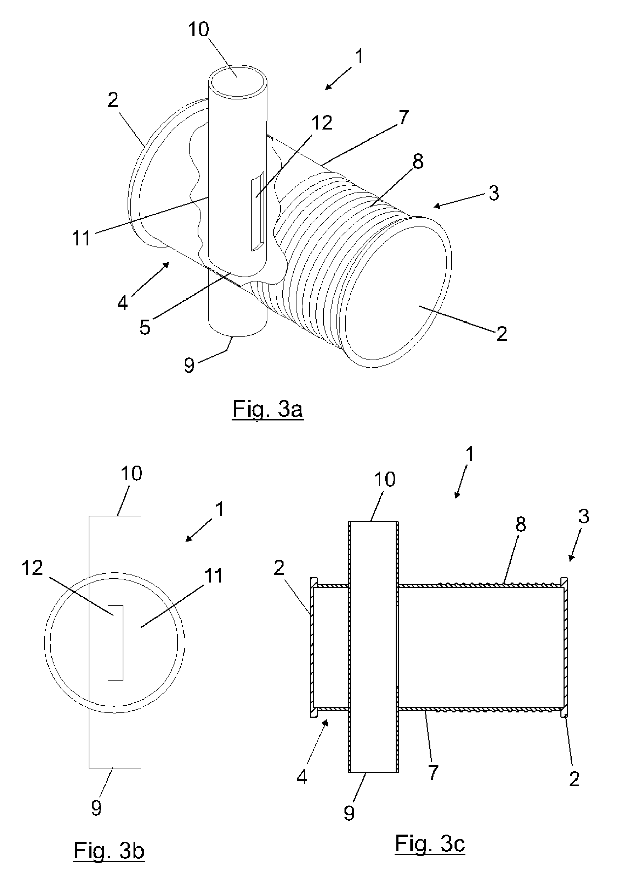

Alternatively, the inlet 5 and outlet 6 of the principal tube 1 can be connected through the interior of the latter by means of a straight through-connection tube 11 which has at least one opening 12 or various indentations in the area shared with the principal tube 1. In this way, the flow continues to be as laminar as possible and entrains the greatest quantity of evaporated precursor. This embodiment is shown in figures 3a, 3b and 3c.

According to a different alternative, the source has a separation element 13 in the interior of the principal tube 1 in the form of a plate or sheet which separates the lower part 3 from the upper part 4 of the latter. This separation element 13 has indentations or holes 14. Thus there will be an isolated area in the upper part 4 of the principal tube 1 where the gas inlet 9 and outlet 10 tubes are arranged so as to be fixed to the exterior face of this principal tube 1. The evaporated precursors pass through the indentations or holes 14 of the separation element 13 and reach the carrier or entrainment flow.

The advantage which the use of this separation element 13 has is that although part of the precursor material remains in solid state when it has not been evaporated and although the flow created by the carrier gas may entrain this solid state precursor, the latter is retained by the separation element 13, which acts as a safety element. Furthermore, this separation element 13 ensures that the carrier gas flow is in a laminar regime and is not turbulent, therefore producing lower thermal and transport losses. This makes the heating and entrainment processes more efficient.

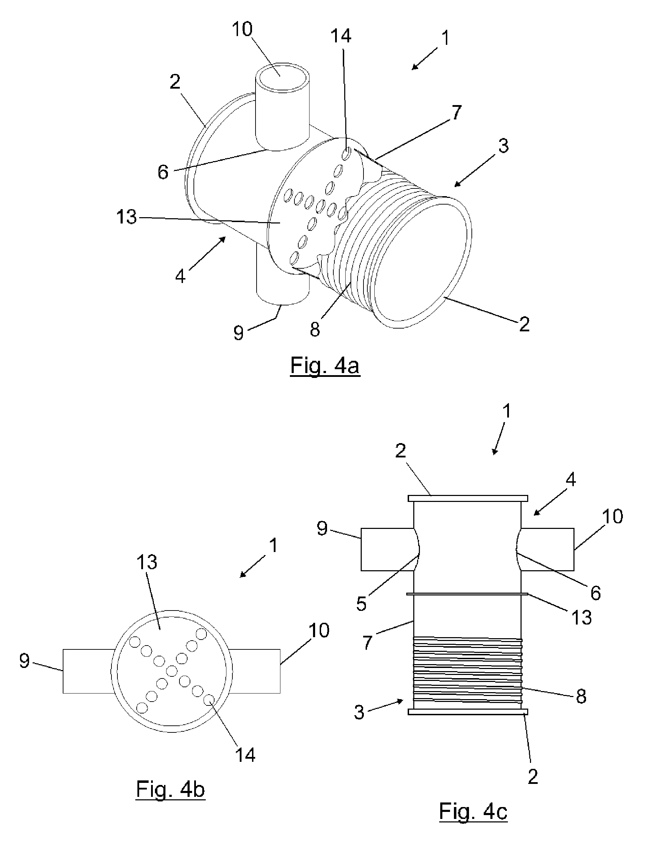

Figures 4a, 4b and 4c show a particular embodiment of the evaporation source of the present invention which has both the straight through-connection tube 11 with at least one opening 12, as well as the separation element 13 in the interior of the principal tube.

A preferred embodiment of the source, which is the object of the present invention, will be described in detail below.

A hollow stainless steel tube is used as the principal tube 1, being 100 millimeters in height and with caps 2 of DN25 diameter at the ends.

Around the principal tube 1, a coiled resistor is arranged to provide heat. A 1.5 kW/m resistor is used which allows a maximum temperature greater than 700° C to be reached.

Preferably, the principal tube 1 is insulated by means of an insulating material to avoid temperature fluctuations, although it can also be made without an insulator. The insulating material can be composed of a material with a ceramic fiber base surrounded by an aluminum sleeve or composed of a low-emissivity material for the principal tube 1 and surrounded by a sleeve to which a vacuum is applied, preventing losses by conduction, or composed of a refractory ceramic material.

In the upper part 4 of the principal tube 1, the inlet 5 and outlet 6 are arranged, both in line, said line transversal to the principal tube 1 forming a certain angle with the latter, preferably a right angle.

Conventionally, in the inlet 5, the carrier gas inlet tube 9 is connected, and in the outlet 6, the carrier gas outlet tube 10 is connected. Both tubes 9 and 10 are made of polished stainless steel and have a diameter of 3/8 of an inch, although other diameters or configurations could be used. Conventionally, around these tubes 9 and 10, a coiled resistor is arranged for providing heat. A 1.5 kW/m resistor is used, which allows a maximum temperature greater than 700° C to be reached.

By means of placing an insulator around the tubes 9 and 10, temperature fluctuations are prevented. This insulator is made of ceramic fiber surrounded by an aluminum sleeve.

Additionally, gauges (thermocouples for example) are placed in the interior and on the exterior of the vertical tube as well as in the interior and on the exterior of the tubes 9 and 10 to control the temperature at all times.

Another object of the present invention is a method of evaporation for transporting chemical precursors which uses the source previously described.

In order to carry out said method, firstly the precursors to be evaporated are placed in the lower part 3 of the principal tube 1 of the source, and said precursors are heated by means of the heating means 8 of the principal tube 1 until they are successfully evaporated.

The carrier gases are introduced into the interior of the principal tube 1 by means of an inlet tube 9 which is connected to the inlet 5 of the tube 1 and are extracted together with the evaporated precursors from the interior of the principal tube 1 by means of an outlet tube 10 connected to the outlet 6.

In the method, which is the object of the invention, the introduction and extraction of the gases from the principal tube 1 is carried out in alignment in a direction transversal to the lateral surface 7 of the principal tube 1, preferably in a direction perpendicular to the lateral surface of this principal tube 1. In this way, the carrier gases enter the principal tube 1 without impacting against the precursors and are separated at a certain distance from the latter. Furthermore, the gases enter in a direction parallel to the surface of the precursors which are evaporated. Thus the evaporated material ascends through the principal tube 1 and meets the carrier gas flow, which gases only collect the evaporated precursors, maintaining a laminar regime or as close as possible thereto, and exit through the outlet 6 of the principal tube, being driven toward the substrate, on which the deposition is carried out by means of condensation.

A preferred embodiment of the method, which is the object of the invention, is described in detail below.

The coiled 1.5 kW/m resistor 8 is connected to the principal tube 1, providing the latter with a temperature of 450° C.

5 grams of solid CuCl precursor are poured into the interior of the principal tube, which, with a molar mass of 98.999 g/mol, means 0.05 moles of this precursor.

A flow control system together with a valve and the source of the entrainment gases is placed in the entrainment gas inlet tube 9.

After the gas outlet tube 10, the process chamber is placed in series with this element, in which the sample holders are arranged, where the evaporated precursor will be deposited. After the process chamber, a 1000-l/s turbomolecular pump is arranged, with a valve for stopping or activating the latter, as well as a guillotine valve as required. In turn, after this pump a 100-m³/h rotor is arranged. By means of this configuration, a base vacuum pressure of less than 1x10⁻⁵ Pa can be reached.

The entrainment or carrier gas is an inert gas, in this case argon. The gas flow will be such that it is required to work at a pressure of 1x10⁻¹ Pa. A flow of 200 sccm (standard cubic centimeters per minute) is estimated, and the turbomolecular pump will be restricted such that the system is at this pressure.

At the given temperature and knowing the chemical properties of the precursor, a vapor pressure of 120.63 Pa is achieved.

With a flow of 200 sccm, a process pressure of 1x10⁻¹ Pa, and an internal temperature of the gases and precursors of 450° C, the quantity of precursor at the outlet of the outlet tube 10 is approximately 1.43x10⁻² g/s, also disregarding any possible condensation along the tube 10 and along the principal tube 1.

According to the foregoing, and assuming:
- Atomic mass: 98.999 g/mol
- Density: 15.0 g/cm³
- Precursor radius: 10 mm
- Evaporator radius: 30 mm
- Guide/source distance: 50 mm
- Guide radius: 8 mm
- Evaporator height: 100 mm
- Solid precursor: 50%
- All of the evaporated precursor will be transported.

The copper atoms are deposited on the substrate at a deposition rate of 7.17x 10⁻² g/s. The chlorine atoms have more affinity among themselves and once the bond has been formed, they are in the form of a gas, being extracted from the process chamber by the pumping system.

The theoretic evaporation rate of CuCl in g/s is shown below for the different temperatures, maintaining the previous parameters at a constant, except the vapor pressure which changes with temperature. Note that for those vapor pressures which are less than the process pressure, evaporation does not occur.

| Temperature (°C) | Vapor pressure (Pa) | Evaporation rate (g/s) |
|---|---|---|
| 100 | 3.2E-09 | - |
| 125 | 7.5E-08 | - |
| 150 | 1.2E-06 | - |
| 175 | 1.4E-05 | - |
| 200 | 1.3E-04 | - |
| 225 | 9.7E-04 | - |
| 250 | 5.9E-03 | - |
| 275 | 3.0E-02 | - |
| 300 | 1.3E-01 | 4.65E-06 |
| 325 | 5.3E-01 | 5.63E-05 |
| 350 | 1.9E-00 | 2.27E-04 |
| 375 | 6.0E-00 | 7.38E-04 |
| 400 | 1.8E+01 | 2.15E-03 |
| 425 | 4.8E+01 | 5.75E-03 |
| 450 | 1.2E+02 | 1.43E-02 |

Once clearly described the present invention, it must be noted that the details of the particular embodiments described above may be modified, provided that the fundamental principle and the essence of the invention are not altered.

## Claims

1. An evaporation source for transporting chemical precursors to a substrate on which the precursors are deposited by means of condensation, the source comprising
- a principal hollow tube (1) with lower and upper removable caps (2) which houses the precursors in its interior and which in turn comprises
- a lower part (3) in which the precursors are housed,
- and an upper part (4) in which there are arranged:
- an inlet (5) through which a carrier gas inlet tube (9) is connected to the interior of the principal tube (1),
- and an outlet (6) through which a carrier gas outlet tube (10) is connected to the interior of the principal tube (1),
- and heating means (8) connected to the lateral surface (7) of the principal tube (1) which cause the precursors to evaporate, said evaporation source for transporting chemical precursors being **characterized in that** the inlet (5) and outlet (6) are arranged on the lateral surface (7) of the principal tube (1) aligned along a common line which passes transversally through the lateral surface (7) of the principal tube (1).

2. The evaporation source for transporting chemical precursors according to claim 1, **characterized in that** the inlet (5) and the outlet (6) are arranged in alignment along a common line perpendicular to the lateral surface (7) of the principal tube (1) and diametrically opposed with respect to the axis of the principal tube (1).

3. The evaporation source for transporting chemical precursors according to any of the preceding claims, **characterized in that**
- the inlet (5) and outlet (6) of the principal tube (1) are connected through the interior of the latter by means of a straight connection tube (11),
- and **in that** said connection tube (11) comprises at least one opening (12).

4. The evaporation source for transporting chemical precursors according to any of the claims 1 to 3, **characterized in that**
- it comprises at least one separation element (13) in the interior of the principal tube (1) which separates the lower part (3) from the upper part (4) of the latter,
- and **in that** said separation element (13) comprises at least one hole (14).

5. The evaporation source for transporting chemical precursors according to any of the preceding claims, **characterized in that** the principal tube (1) is made of a metallic material selected from among stainless steel, copper, titanium and a combination of the aforementioned materials.

6. The evaporation source for transporting chemical precursors according to any of the preceding claims, **characterized in that** the principal tube (1) comprises a coating made of an alloy of elements selected from among nickel, vanadium, molybdenum, chrome and a combination of the aforementioned elements.

7. The evaporation source for transporting chemical precursors according to any of the preceding claims, **characterized in that** the heating means (8) comprise a resistor arranged around the principal tube (1).

8. The evaporation source for transporting chemical precursors according to any of the claims 1 to 6, **characterized in that** the heating means (8) comprise at least one heating lamp arranged externally to the principal tube (1).

9. The evaporation source for transporting chemical precursors according to any of the preceding claims, **characterized in that** it comprises thermocouples arranged in a location selected from among the interior and the exterior of the principal tube (1) and a combination of both for controlling the temperature.

10. A method of evaporation for transporting chemical precursors which uses the source of claims 1 to 9 which comprises the steps of
- arranging precursors in the lower part (3) of the principal tube (1) of the source,
- heating the precursors by means of heating means (8) of the principal tube (1) to evaporate the former,
- introducing carrier gases into the interior of the principal tube (1) by means of an inlet tube (9) connected to the inlet (5) of said principal tube (1),
- and extracting the carrier gases together with the evaporated precursors from the interior of the principal tube (1) by means of an outlet tube (10) connected to the outlet (6) of said principal tube (1), said method of evaporation for transporting chemical precursors being **characterized in that** introducing and extracting the gases from the principal tube (1) is carried out in alignment in a direction transversal to the lateral surface (7) of the principal tube (1).

11. The method of evaporation for transporting chemical precursors according to claim 10, **characterized in that** introducing and extracting the gases from the principal tube (1) is carried out in alignment in a direction perpendicular to the lateral surface (7) of the principal tube (1) and diametrically opposed with respect to the axis of the principal tube (1).

12. The method of evaporation for transporting chemical precursors according to any of the claims 10 to 11, **characterized in that** the carrier gases introduced into the interior of the principal tube (1) are selected from among argon, nitrogen, oxygen, any noble gas, hydrogen, fluorine, chlorine and a combination of the aforementioned gases.

13. The method of evaporation for transporting chemical precursors according to any of the claims 10 to 12, **characterized in that** the precursors arranged in the lower part (3) of the principal tube (1) of the source are halides.
